# EUROPEAN PATENT APPLICATION

(11) **EP 4 339 701 A1**
(43) Date of publication of application: **20.03.2024**
(21) Application number: 22807202.1
(22) Date of filing: 24.03.2022
(51) Int. Cl.: G03F 7/004, G03F 7/038, G03F 7/039, G03F 7/20, G02B 5/20

(54) **BLACK RESIST COMPOSITION AND METHOD FOR FORMING BLACK PATTERN BY NEAR-INFRARED PHOTOLITHOGRAPHY**

(30) Priority: 10.05.2021 JP 2021079441
(71) Applicant: Echem Solutions Japan Inc., Kawasaki-shi, Kanagawa, 213-0012 (JP)
(72) Inventor: IGAWA, Akihiko, Kawasaki-shi, Kanagawa 213-0012 (JP); SHIODA, Hidekazu, Kawasaki-shi, Kanagawa 213-0012 (JP)
(74) Representative: Weickmann & Weickmann PartmbB
(86) International application number: PCT/JP2022/013787
(87) International publication number: WO 2022/239497

(57) **Abstract**

The present invention proposes a new procedure about a photolithographic method for forming a black pattern such as a black matrix. The present invention relates to a black resist composition suitable for this new process and excellent in light-blocking effect. The present invention relates to a black resist composition including a near-infrared-permeable black pigment (A), a sensitizing dye (B) having absorption in a near-infrared region, a radical polymerization initiator or acid generator (C), and a binder resin (D) as essential components. The black pigment (A) here used is preferably a lactam-based pigment, a perylene-based pigment, and/or an azomethine-based pigment, and a cyanine dye, a squarylium dye, and/or a phthalocyanine dye are/is contained as suitable sensitizing dye(s), together with the black pigment. The present invention relates to a novel photolithographic process of a black pattern with application of near-infrared light.

## Description

### BACKGROUND OF THE INVENTION

### FIELD OF THE INVENTION

The present invention relates to a novel method for forming a black pattern such as a black matrix by a photolithographic method. The present invention is drawn to a resist composition including a black pigment suitable for the method, and relates to a black resist composition having near-infrared photosensitivity.

### DESCRIPTION OF THE RELATED ART

A color flat panel is used in any electronic device with a screen, such as a liquid crystal television, a liquid crystal monitor, and a smartphone screen. Such a flat panel mostly includes a color filter where pixels of respective colors of red, green, blue, or cyan, yellow, and magenta are formed. In such a color filter, a black matrix having grid-like and stripe-like openings is formed on a surface of a transparent substrate such as glass, and pixels of dyes displaying such respective colors are formed. A black matrix is a light-blocking material which provides a clearer image by suppression of color mixing of light and light leakage from each pixel and enhancements in contrast and color visibility. Such a black matrix, while has been formerly formed by deposition/patterning of a Cr thin film in a grid-like manner, is currently formed by a photolithographic method entirely utilizing a photosensitive resin composition (resist composition) including a black pigment. Such a photolithographic method includes a relatively simple step as compared with patterning of a Cr thin film or the like, and is excellent in terms of production cost. In particular, a direct exposure technique with semiconductor laser or the like has recently attracted attention, and a highly fine black matrix can be efficiently produced.

A black resist composition including carbon black as a black pigment is mainly used as a resist composition for production of a black pattern such as a black matrix by a photolithographic method. Ultraviolet light, in particular, g-ray (wavelength 436 nm), h-ray (wavelength 405 nm), or i-ray (wavelength 365 nm) is applied in a light source for resist exposure.

As described above, a black matrix is formed for an enhancement in contrast between adjacent color pixels, and thus is demanded to have a high light-blocking effect. Such a demanded requirement causes technical inconsistencies with a pattern formation mechanism by a photolithographic method. In other words, carbon black as a black pigment included in a conventional black resist composition has a high light-blocking effect and thus is a suitable material for response to the above demanded requirement. However, carbon black has a broad light absorption wavelength range, and can absorb not only visible light, but also ultraviolet rays (g-ray, h-ray, i-ray). Therefore, ultraviolet rays serving as exposure light can contribute to photoreaction on an upper layer portion of a resist film, but cannot reach a lower portion of the resist film, in an exposure step of a photolithographic method, and a problem caused is that, when a negative resist is used, an upper layer portion of a resist film is cured, but a lower portion of the film is still uncured.

Any measure that has been heretofore taken against such technical inconsistencies has been mainly the change in configuration of a black pigment. There have been reported measures such as a mixture of carbon black and an extender pigment, serving as a black pigment (Patent Document 1), an application of a black pigment having decreased proportion of carbon black by auxiliary use of pigments of different colors mixed and blackened (Patent Documents 2 and 3), and a black pigment by improvements in physical properties of carbon black (Patent Documents 4 and 5).

### Prior Art Document

### Patent Document

Patent Document 1
   Japanese Patent Application Laid-Open No. 11-149153
Patent Document 2
   International Publication No. WO2013/115268
Patent Document 3
   Japanese Patent Application Laid-Open No. Hei 2000-227654
Patent Document 4
   International Publication No. WO2008/066100
Patent Document 5
   Japanese Patent Application Laid-Open No. 2006-257110

### SUMMARY OF THE INVENTION

### TECHNICAL PROBLEM

However, problems are not deemed to be fundamentally solved by the above conventional measures, and the difference in photoreaction between an upper layer portion and a lower portion of a resist film can be caused even with such measures. The reason is because a black pigment used in such measures still includes carbon black and thus absorbs ultraviolet rays. In recent years, there has been a need for pattern formation of a black matrix or the like, and a rectangular pattern having an edge effect in a cross section shape and having verticality has been often needed. It has been difficult for any prior art to sufficiently satisfy such requirements.

Furthermore, development of a display device by a new technique of a combination of a micro LED and a quantum dot has been increasingly estimated in recent years. This display device is required to have a height of about 10 µm for formation of a quantum dot layer, and thus a grid-like partition having a height of 10 µm or more is required to be formed. A black pattern for, for example, an enhancement in contrast is tried to be applied to this grid-like partition.

The film thickness of a black matrix in a color filter of a conventional liquid crystal flat panel has been a film thickness of at most about 5 µm. Thus, the above problems still exist, but it has been possible to deal with the problems by conventional measures at the least. However, it is extremely difficult for a conventional technique to deal with formation of a black pattern not only having a film thickness of 10 µm or more suitable for the above novel display device, but also including a cross section having verticality.

The present invention has been made in view of the above circumstances, and relates to a method for producing a black pattern such as a black matrix by a photolithographic method, and proposes a non-traditional process. It also provides a novel black resist composition not only exhibiting light-blocking effect comparable with that of a carbon black-containing resist composition, in a visible-light region, but also enabling exposure light to permeate without any influence of a film thickness in an exposure step.

### SOLUTION TO PROBLEM

The present inventors have discussed that application of a new process changed in exposure light for an exposure step is required in order to solve problems experienced by a photolithographic method with the above conventional black resist composition. Black is essentially a color having a broad absorption wavelength band, and it is difficult to allow a black pigment to not only permit permeation of conventional exposure light, but also exhibit light-blocking effect.

Specifically, the present inventors have made studies about a photolithographic method with application of near-infrared light as exposure light. Furthermore, the present inventors have made intensive studies about a black resist composition not only including a predetermined black pigment, but also having near-infrared photosensitivity and also having light-blocking effect equivalent to or more than that of conventional one, as a resist composition capable of dealing with a photolithographic method with application of near-infrared light, and as a result, have conceived the present invention.

In other words, the present invention relates to a black resist composition including the following component (A) to component (D) as essential component:
Component (A): a near-infrared-permeable black pigment;
Component (B): a sensitizing dye having absorption in a near-infrared region;
Component (C): a radical polymerization initiator or acid generator; and
Component (D): a binder resin.

The present invention relates to a black resist composition capable of dealing with a photolithographic method with near-infrared light as an exposure light source. The composition is characterized by simultaneously satisfying suitable photosensitivity and light-blocking effect with a combination of a near-infrared-permeable black pigment (component (A)) and a sensitizing dye having absorption in a near-infrared region (component (B)). Hereinafter, a configuration of the black resist composition of the present invention, and a photolithographic method are described. The near-infrared light serving as an exposure light source in the present invention is light at a wavelength band of 700 nm or more and 1000 nm or less.

### (I) Configuration of the black resist composition of the present invention

### · Component (A): black pigment

The black pigment to be applied in the present invention is a pigment that absorbs light including ultraviolet rays and visible rays at a level comparable with carbon black to thereby block light and that is permeable to near-infrared light.

The black pigment that is permeable to near-infrared light described above preferably includes at least any of a lactam-based pigment, a perylene-based pigment, and an azomethine-based pigment.

Specific examples of the lactam-based pigment include Irgaphor Black S 0100 CF from BASF SE. Specific examples of the perylene-based pigment include Perylene black31 (PB31), and specific examples of the azomethine-based pigment include Chromofineblack A1103 from Dainichiseika Color & Chemicals Mfg. Co., Ltd. A black paste obtained by addition of a dispersant, a surfactant, and/or the like to the above black pigment and dispersion of the resultant in an organic solvent is commercially available, and such a black paste can also be used. The black pigment in the present invention here includes no carbon black.

Herein, permeability of the black resist composition of the present invention to near-infrared light can allow for permeation of 50% or more of near-infrared light at a wavelength of 700 nm or more and 1000 nm or less in a resist film having a thickness of 10 µm, the film being formed from a resist composition including 15% by weight of the above black pigment based on the total solid content of the resist.

### · Component (B): sensitizing dye

A certain type of dye absorbs near-infrared light and thus is in an excited state, and the energy transfers to a polymerization initiator and/or an acid generator. Such a dye is known to be able to result in the occurrence of radical generation or acid generation, and is called a sensitizing dye. In the present invention, a sensitizing dye which absorbs near-infrared light at a wavelength of 700 nm or more and 1000 nm or less is preferable.

In the present invention, the above sensitizing dye preferably includes at least any of a cyanine dye, a squarylium dye, and a phthalocyanine dye.

Specific examples of the cyanine dye include IR-797 and IR-820 from Sigma-Aldrich Co. LLC, and IRT from Showa Denko K.K. Specific examples of the squarylium dye include 2,4-di-3-guaiazulenyl-1,3-dihydroxycyclobutenediylium dihydroxide bis(inner salt) and 2,4-bis[4-(N,N-diisobutylamino)-2,6-dihydroxyphenyl]squaraine. Furthermore, specific examples of the phthalocyanine dye include 5,9,14,18,23,27,32,36-octabutoxy-2,3-naphthalocyanine copper (II). A large number of dyes applicable to the present invention are listed in "Catalog of Reagents for Material Science Studies (2004), pages 106 to 109" of Sigma-Aldrich Co. LLC, and in the page "near-infrared absorbing dyes" in the website of Tokyo Chemical Industry Co., Ltd., and are readily commercially available.

It has been confirmed in the present invention that the above-listed cyanine dyes, squarylium dyes, and phthalocyanine dyes effectively function. In particular, cyanine dyes (IR-797, IR-820, and IRT) respectively have maximum absorption wavelengths (λmax) of 813 nm, 820 nm, and 817 nm. In the present invention, a LED can be used as a light source for use in near-infrared exposure, and a LED light source widely marketed is an 850-nm LED. The above-listed cyanine dyes have maximum absorption wavelengths close to the wavelength of this LED light source, and thus are deemed to be suitable sensitizing dyes.

Sensitizing dyes which have been formerly used in conventional black resist compositions are, for example, benzophenone-based compounds (for example, 4,4'-bis(diethylamino)benzophenone), acridine-based compounds (for example, 9-phenylacridine), and anthracene-based compounds (for example, 9,10-dibutoxyanthracene). These sensitizing dyes, although are widely used as sensitizers for longer wavelengths of ultraviolet rays, have no absorbability in a near-infrared region and cannot each function as the sensitizing dye in the present invention.

### · Component (C): polymerization initiator or acid generator

This component generates radical or acid with energy from the sensitizing dye excited by light irradiation, to thereby form a resist film. Here, it is not always true that energy transfer effectively progresses in any polymerization initiator or acid generator which is to be combined with the sensitizing dye having absorption in a near-infrared region in the present invention. In the present invention, preferable polymerization initiator and acid generator are effectively an iodonium salt, a triazine compound, and a boron ion complex.

Specifically, the iodonium salt is preferably diaryliodonium phosphate (for example, IK-1 from San-Apro Ltd.), the triazine compound is preferably a bischloromethyl-S-triazine compound (for example, TFE-triazine, TME-triazine, MP-triazine, and dimethoxytriazine from Sanwa Chemical Co., Ltd.), and the boron ion complex is preferably tetrabutylammonium=butyltriphenylborate (P3B from Showa Denko K.K.) or tetrabutylammonium=butyltrinaphthylborate (N3B from Showa Denko K.K.), because these salts are applicable.

### · Component (D): binder resin

The binder resin is compounded for formation of a uniform coating film in coating of a substrate with a photosensitive resin composition adjusted. The resin also functions as a resin for dissolution of an unnecessary portion of a pattern with a developer in a development step of a photolithographic method. The binder resin which can be applied is basically one for use in a conventional resist resin composition, and the type is not particularly limited as long as the above function can be performed.

The binder resin is representatively an alkali-soluble resin. Specific examples include an acrylic resin. A copolymer of an ethylenically unsaturated monomer containing a carboxyl group or a hydroxyl group and other copolymerizable ethylenically unsaturated monomer is preferable in order to have alkali solubility. A novolak resin and a polyhydroxystyrene resin (PHS resin) are also excellent in film formability and alkali solubility, and suitable for the present invention. Many products of these resins are commercially available, and many prior arts about methods for producing these resins are also published (for example, Japanese Patent Application Laid-Open No. 2006-58385 and Japanese Patent No. 6226104).

The resist composition is obtained as a negative resist composition by mixing of any of a radical polymerizable monomer or a crosslinking agent with the binder resin. Meanwhile, the binder resin for use in a positive resist composition can be, for example, a protective group-attached novolak resin or a protective group-attached PHS resin. Methods for producing such protective group-attached resins are also known (for example, detailed in Japanese Patent Application Laid-Open No. 2019-204036).

### · Component (E): radical polymerizable monomer or crosslinking agent (optional additive)

The component (A) to component (D) described above are essential components of the black resist composition of the present invention. A negative resist composition can be obtained by mixing of any of a radical polymerizable monomer or a crosslinking agent with these components, as described above.

The radical polymerizable monomer for use in the present invention is preferably a polyfunctional monomer. Examples include diacrylates or dimethacrylates of alkylene glycols such as ethylene glycol and propylene glycol; diacrylates or dimethacrylates of polyalkylene glycols such as polyethylene glycol and polypropylene glycol; and polyacrylates or polymethacrylates of tri- or higher polyhydric alcohols such as glycerin, trimethylolpropane, pentaerythritol, and dipentaerythritol.

In particular, polyacrylates or polymethacrylates of tri- or higher polyhydric alcohols are preferable, and specific examples preferably include trimethylolpropane triacrylate, trimethylolpropane trimethacrylate, pentaerythritol triacrylate, pentaerythritol trimethacrylate, pentaerythritol tetraacrylate, pentaerythritol tetramethacrylate, dipentaerythritol tetraacrylate, dipentaerythritol tetramethacrylate, dipentaerythritol hexaacrylate, and dipentaerythritol hexamethacrylate, particularly preferably include trimethylolpropane triacrylate, pentaerythritol triacrylate, and dipentaerythritol hexaacrylate (DPHA) because reactivity is high. These polyfunctional monomers can be used singly or as a mixture of two or more kinds of these monomers.

In the present invention, the crosslinking agent is suitably an alkoxymethylated melamine. The alkoxymethylated melamine has a structure where a hydrogen atom in an amino group of the melamine is fully or partially substituted with an alkoxymethyl group. Specific examples of the alkoxymethylated melamine include methoxymethylated melamine, ethoxymethylated melamine, propoxymethylated melamine, and butoxymethylated melamine.

The alkoxymethylated melamine can also be a commercially available product. Examples include Cymel 300 (methoxymethylated melamine) and Cymel 303 (methoxymethylated melamine) from Allnex, and Nicalac MW-30HM (methoxymethylated melamine) and Nicalac MW-40 (methoxy/butoxy-mixed methylated melamine) from Sanwa Chemical Co., Ltd. These melamines can be used singly or in combinations of a plurality of such melamines, in the composition of the present invention.

A polyfunctional epoxy compound can also be used as the crosslinking agent. For example, a polyfunctional epoxy compound can be used which has, for example, an alkylene glycol backbone such as ethylene glycol or propylene glycol, a diphenylmethane backbone, a dinaphthylmethane backbone, a triazine backbone, a biphenyl backbone, a phenol/novolak backbone, a tetraphenylethane backbone, or a bisphenol backbone.

Such compounds are widely commercially available. For example, Epolight 40E and Epolight 70P from Kyoeisha Chemical Co., Ltd., TEPIC-S from Nissan Chemical Corporation, Epicion 830 from DIC Corporation, and JER-YX-4000 and JER-604 from Mitsubishi Chemical Corporation can be used. Such polyfunctional epoxy compounds can be used singly or in combinations of a plurality of such compounds, in the composition of the present invention.

The melamine compound and the polyfunctional epoxy compound can also be combined and thus used as the crosslinking agent.

The compounding rate of each of the above components (A) to (E) is preferably as follows based on 100 parts by weight of the total solid content of the resist composition. (a) Black pigment: 3 parts by weight or more and 50 parts by weight or less, more preferably 10 parts by weight) or more and 30 parts by weight or less.

If the rate of the black pigment is below the above range, light-blocking effect may decrease. If the rate exceeds the above range, near-infrared light is absorbed to thereby cause photoreaction homogeneity in a film thickness to be affected. (b) Sensitizing dye: 0.5 parts by weight or more and 10 parts by weight or less, more preferably 1 part by weight or more and 5 parts by weight) or less.

If the rate of the sensitizing dye is below the above range, sensitivity may decrease due to insufficient excitation with infrared light. If the rate exceeds the above range, the sensitizing dye by itself, on the contrary, excessively absorbs infrared light energy, to cause sensitivity to be decreased. (c) Polymerization initiator or acid generator: 0.5 parts by weight or more and 10 parts by weight or less, more preferably 1 part by weight or more and 7 parts by weight or less.

If the rate of the component (c) is below the above range, sensitivity may decrease. If the rate exceeds the above range, sensitivity is extremely high and even an unexposed portion in the vicinity of an exposed portion is subjected to reaction, to lead to deteriorations in resolution and contrast. (d) Binder resin: 30 parts by weight or more and 80 parts by weight or less, more preferably 40 parts by weight or more and 75 parts by weight or less.

If the rate of the binder resin is below the above range, coating film forming ability is decreased and a uniform film is hardly obtained. If the rate exceeds the above range, image forming function is decreased. (e) Radical polymerizable monomer or crosslinking agent: 10 parts by weight or more and 50 parts by weight) or less, more preferably 15 parts by weight or more and 45 parts by weight or less.

If the rate of the component (e) is below the above range, radical polymerization reactivity or crosslinking reactivity is decreased, and if the rate exceeds the above range, workability is decreased due to excess reaction.

### · Other additive(s)

In addition to the above components, for example, a surfactant for film formation uniformity in spin coating and prevention of the occurrence of any radial stripe called striation, a dispersant and/or a dispersion aid for an enhancement in pigment dispersibility, a second solvent/third solvent for an enhancement in solubility of each of the solid components and adjustments of the solvent volatilization speed in spin coating and the solvent evaporation speed in baking, in addition to the main solvent, can be appropriately added.

### (II) Method for forming a black pattern of the present invention

Next, the method for forming a black pattern such as a black matrix of the present invention is described. The method for forming a black pattern of the present invention basically follows a pattern forming method by a conventional photolithographic method. Such a pattern forming method by a photolithographic method is configured from steps including a film formation step of applying a resist composition to a substrate and drying the resultant to thereby form a resist film, an exposure step of exposing the resist film to allow photoreaction to occur in the resist film, and a development step of treating the resist film with a developer to thereby remove an excess resist film and thus obtain a desired pattern. The present invention is characterized by not only application of the black resist composition of the present invention, as a resist composition for resist film formation, but also application of near-infrared light at a wavelength of 700 nm or more and 1000 nm or less, as a light source in the exposure step. Hereinafter, the steps of the method for forming a black pattern of the present invention are each described.

### (Film formation step)

The substrate for resist film formation is a transparent substrate, for example, a transparent glass substrate or a transparent film in consideration of an original object of a black pattern such as a black matrix, the object being to block light on a main portion on a transparent substrate, but the substrate is not limited to such a substrate. For example, a silicon wafer, a ceramic substrate, an aluminum substrate, a SiC wafer, a GaN wafer, a substrate of metal such as copper, or a substrate where a film of metal such as copper is formed, can be appropriately used. The substrate may be an unprocessed substrate, or may be a substrate where an electrode and/or an element are/is formed.

The resist composition to be applied to the substrate is a black pigment-containing resist of the present invention, as described above. The method for applying the resist composition is not particularly limited. Rotation application with a spin coater is commonly adopted, and any of spray coating with a spray coater, slot coating, roll coating, an ink-jet method, and the like may be adopted.

The resist composition applied to the substrate is typically dried (pre-baked) by a heating treatment with a hot plate or a hot air type oven. The heating temperature is preferably 80°C or more and 140°C or less, more preferably 90°C or more and 120°C or less. The heating time varies depending on a heating apparatus, and is preferably about 30 seconds or more and 300 seconds or less, more preferably about 60 seconds or more and 180 seconds or less in the case of use of a hot plate. The heating time is preferably about 5 minutes or more and 60 minutes or less, more preferably about 10 minutes or more and 30 minutes or less in the case of use of a hot air type oven.

The film thickness of the resist film is not particularly limited, and appropriately adjusted depending on an application applied and a required pattern. For example, when a black matrix for a color filter is formed, the film thickness is preferably 1 µm or more and 5 µm or less, more preferably 2 µm or more and 3 µm or less. In the case of a black pattern for devices, where the above quantum dot is applied, the film thickness of 10 µm or more and 15 µm or less may be needed in partition usage where the quantum dot is packed.

### (Exposure step)

On the contrary to a conventional photolithographic method where ultraviolet rays (wavelength: about 200 to 500 nm) are applied, the exposure step in the present invention includes exposure with near-infrared light at a wavelength of 700 nm or more and 1000 nm or less. A light source emitting near-infrared light is suitably laser or a LED, and an exposure apparatus designed so that an optical system corresponds to parallel light is preferable. Herein, a light source which radiates light including near-infrared light in a broad wavelength band, such as a xenon lamp, can also be used. In this case, light in a wavelength band of 700 nm or more and 1000 nm or less can be extracted with a bandpass filter or the like and then serve as a light source. In the exposure step, the resist film is exposed with a photomask having a desired pattern designed, being interposed. According to recent progress of information technologies/image processing technologies, a technique about a photolithographic method is known which involves direct exposure of a required pattern with a beam-like ray without use of any photomask (direct writing exposure or mask-less exposure). Such mask-less exposure can be adopted in the black resist composition and the photolithographic method of the present invention.

After the exposure step, a step of heating the resist film can be, if necessary, included before the development step. The heating may be referred to as "post-exposure heating or PEB (Post Exposure Bake). In PEB, the heating temperature can be, for example, 70°C or more and 150°C or less, preferably 70°C or more and 120°C or less, and the heating time can be 30 seconds or more and 300 seconds or less, preferably 60 seconds or more and 180 seconds or less in the case of use of a hot plate. PEB is preferably applied in the case of a resist composition called a three-component chemically amplified negative resist, or a positive resist with de-protection reaction.

### (Development step)

A desired pattern can be obtained by development of the exposed resist film with a developer. The development can be performed by a method such as a dipping method, a paddle method, or a spray method. In the development step, an exposed portion is crosslinked and solidified with photoreaction and remains as a pattern, and an unexposed portion is eluted and removed, in the case of a negative resist film. An exposed portion is eluted and removed and an unexposed portion remains as a pattern, in the case of a positive resist film.

An aqueous alkali solution is preferably used as the developer. Specific examples of the aqueous alkali solution include (i) aqueous solutions of inorganic alkalis such as sodium hydroxide, sodium carbonate, sodium silicate, and ammonia, (ii) aqueous solutions of organic amines such as ethylamine, diethylamine, triethylamine, and triethanolamine, and (iii) aqueous solutions of quaternary ammonium salts such as tetramethylammonium hydroxide and tetrabutylammonium hydroxide. More preferable examples of the developer include an aqueous tetramethylammonium hydroxide solution. The concentration of tetramethylammonium hydroxide in the developer is preferably 0.1% by mass or more and 10% by mass or less, more preferably 0.4% by mass or more and 2.5% by mass or less. A surfactant can also be appropriately added to the developer in order to enhance penetrativeness.

### (Other step)

After the development step, the pattern and the substrate are preferably washed with a rinse liquid. The rinse liquid is suitably ultrapure water.

After pattern formation, baking (post-baking) can also be further performed in order to tightly fix the pattern to the substrate and to enhance physical and chemical resistance of the pattern by itself. Post-baking conditions can be appropriately determined, and the heating temperature is generally set to be higher than the heating temperature in pre-baking by 10°C or more and 30°C or less.

The above-mentioned photolithographic method of the present invention can form a black pattern such as a black matrix on a substrate. The black resist composition of the present invention can allow for formation of a suitable black pattern having no difference in photoreaction depending on the film thickness, and is also excellent in light-blocking effect in a visible-light region. A black pattern including the black pigment formed by the present invention has a sharp pattern edge and retains a favorable rectangle also in a cross section shape.

### ADVANTAGEOUS EFFECTS OF THE INVENTION

As described above, the present invention solves conventional problems by application of near-infrared light as an exposure light source in a formation process of a black pattern such as a black matrix by a photolithographic method. The black resist composition of the present invention enables a black pattern as a desired pattern to be efficiently produced by application of near-infrared light. Herein, photoreaction can be allowed to homogeneously progress at a high sensitivity without any influence of the resist film thickness. The black resist composition of the present invention not only has the ability to block light in a visible-light region at a level comparable with carbon black, but also enables a rectangle pixel pattern to be formed.

### DETAILED DESCRIPTION OF THE PREFERRED EMBODIMENTS

Hereinafter, embodiments of the present invention are described. In the present embodiment, three binder resins (alkali-soluble resins) were synthesized (designated as "resin F-1", "resin F-2", and "resin F-3") and respective black pigments and additives were added to these resins, and thus black resist compositions in Examples and Comparative Examples were produced. Such respective resist compositions were used for production of black matrices by a photolithographic method.

### Synthesis of [binder resin (alkali-soluble resin)]

### Synthesis of resin F-1

A four-necked flask was charged with isopropyl alcohol and kept in an oil bath at 80°C under sealing with nitrogen, and charged with methyl methacrylate/methacrylic acid/styrene at a weight ratio of 30/40/30 under stirring, and thus a copolymer was synthesized. Furthermore, 40 parts by weight of glycidyl methacrylate was added and the resultant was subjected to re-precipitation with pure water, filtration, and drying, and thus a methyl methacrylate/methacrylic acid/styrene copolymer partially including glycidyl methacrylate added was obtained. The copolymer produced had an average molecular weight (Mw) of 17100 and an acid value of 113 (mgKOH/g). The acrylic polymer is designated as "F-1".

### Synthesis of resin F-2

A separable flask equipped with a thermometer, a stirrer and a reflux condenser was charged with 100 parts of o-cresol, 32.5 parts of 92% paraformaldehyde and 1.0 part of oxalic acid, and reaction was made under reflux for 4 hours. Then, 50.0 parts of propylene glycol monomethyl ether acetate was added, and heated to 120°C under removal of water distilled out. Furthermore, after reaction at 120°C for 5 hours, the propylene glycol monomethyl ether acetate was taken out by heating to 180°C and depressurizing. A resin molted at 180°C was extracted and cooled, and thus a solid o-cresol novolak resin was obtained. The resin had a weight average molecular weight of 6000 by a gel permeation chromatographic method (in terms of polystyrene). The novolak resin is designated as "F-2".

### Synthesis of resin F-3

A novolak resin was synthesized where a phenolic hydroxyl group was protected by an alkoxyalkyl group. Novolak resin F-2 obtained above was dissolved in cyclopentanone so that the concentration of a resin-containing fraction was 15%, and 130 g of this resin solution was charged with 3.6 mg of p-toluenesulfonic acid monohydrate. After 7.8 g of ethyl vinyl ether was dropped into this resin solution, reaction was made at room temperature for 3 hours. Thereafter, ion-exchange water was added to this reaction solution in order to remove an acid catalyst and the resultant was stirred, thereafter the resultant was left to still stand, and a washing step of taking out an organic layer portion by liquid separation was repeated five times. The organic layer finally taken out was concentrated also for water removal. A resin solution having a resin concentration of 59% was thus obtained. The resin obtained was analyzed by ¹H-NMR, and it was found that 45% of the phenolic hydroxyl group in the novolak resin was protected with a 1-ethoxyethyl group. The protective group-attached novolak resin is designated as "F-3".

### [Production of black resist composition]

### Example 1

F-1 as an alkali-soluble resin, dipentaerythritol hexaacrylate (DPHA) as a radical polymerizable monomer, and tetrabutylammonium=butyltriphenylborate (P3B) as a polymerization initiator were dissolved in propylene glycol monomethyl ether acetate (PGMEA) as a solvent, and thus a base negative resist composition was obtained. The resist composition was mixed with lactam black as a black pigment component and a cyanine dye (IRT) as a sensitizing dye, and thus a black resist composition was obtained. The weight ratio of the respective component solid contents was as shown in Table 1 below. Here, a surfactant, a dispersant, and a dispersion aid were appropriately added in order to enhance film formability and pigment dispersibility.

### Example 2

The polymerization initiator and the sensitizing dye in Example 1 were changed, and a black resist composition was produced. In the present Example, a black resist composition was obtained in the same manner as in Example 1 except for use of triazine (TME-triazine from Sanwa Chemical Co., Ltd.) as a polymerization initiator and IR-797 as a sensitizing dye. The configuration is as shown in Table 1.

### Example 3

In the present Example, a black resist composition was obtained in the same manner as in Example 1 except for use of an iodonium salt (diaryliodonium phosphatetriazine: IK-1) as a polymerization initiator and IR-820 as a sensitizing dye. The configuration is as shown in Table 1.

### Example 4

F-2 as an alkali-soluble resin, melamine (Nicalac MW-30HM from Sanwa Chemical Co., Ltd.) as a crosslinking agent, and triazine (TFE-triazine from Sanwa Chemical Co., Ltd.) as an acid generator were dissolved in PGMEA, and thus a base resist composition was adjusted (the solution is designated "as solution A"). Solution A was a negative resist to be optically crosslinked by use of ultraviolet rays including g-, h-, and i-rays in an exposure light source. IR-797 dissolved in γ-butyrolactone was mixed with solution A, perylene black (PB31) as a black pigment component was further mixed, and thus a black resist composition was obtained. The configuration is as shown in Table 1.

### Example 5

F-3 as an alkali-soluble resin and triazine (TME-triazine from Sanwa Chemical Co., Ltd.) as an acid generator were dissolved in PGMEA, and thus a base resist composition was adjusted (the solution is designated "solution B"). Solution B functioned as a photodissociation type positive resist by use of ultraviolet rays including g-, h-, and i-rays in an exposure light source. IR-797 dissolved in γ-butyrolactone was mixed with solution B, an azomethine-based pigment (A1103) as a black pigment was further mixed, and thus a black resist composition was obtained. The configuration is as shown in Table 1 below.

### Comparative Example 1

A black resist composition was produced in the same manner as in Example 1 except that IRT as a sensitizing dye was not added in Example 1.

### Comparative Example 2

A black resist composition was produced in the same manner as in Example 1 except that the sensitizing dye in Example 1 was changed from IRT to 9-phenylacridine (9PA) well-known as a sensitizer at longer wavelengths of ultraviolet rays.

### Comparative Example 3

A black resist composition was produced in the same manner as in Example 1 except that the black pigment component in Example 1 was changed from the lactam-based pigment to carbon black.

### Comparative Example 4

A black resist composition was produced in the same manner as in Example 4 except that IRT as the sensitizing dye in Example 4 was not added.

### Comparative Example 5

A solution having a composition where the sensitizing dye (IR-797) and the black pigment (perylene black) in Example 4 were not added, namely, solution A was adopted as a resist composition in Comparative Example 5.

The configuration of each of the resist compositions of Example 1 to Example 5 and Comparative Example 1 to Comparative Example 5, produced in the present embodiment, is as shown in Table 1 below.

**[Table 1]**

| Number in brackets: solid weight ratio | | | | | | | |
|---|---|---|---|---|---|---|---|
| | | Composition of base resist | | | | Sensitizing dye | Black pigment |
| | | Alkali-soluble resin | Monomer | Crosslinking agent | Polymerization initiator Acid generator | | |
| Example 1 | | F-1 (40) | DPHA (40) | - | P3B (3) | IRT (1) | Lactam black (16) |
| Example 2 | | F-1 (40) | DPHA (40) | - | Triazine (3) | IR-797 (1) | Lactam black (16) |
| Example 3 | | F-1 (40) | DPHA (40) | | IK-1 (4) | IR-820 (1) | Lactam black (15) |
| Example 4 | | F-2 (55) | - | Melamine (15) | Triazine (3) | IR-797 (2) | Perylene black (25) |
| Example 5 | | F-3 (75) | - | - | Triazine (2) | IR-797 (2) | Azomethine black (29) |
| Comparative Example 1 | | F-1 (40) | DPHA (40) | - | P3B (3) | None | Lactam black (16) |
| Comparative Example 2 | | F-1 (40) | DPHA (40) | - | P3B (3) | 9PA (1) | Lactam black (16) |
| Comparative Example 3 | | F-1 (40) | DPHA (40) | - | P3B (3) | IRT (1) | Carbon black (6) |
| Comparative Example 4 | | F-2 (55) | - | Melamine (15) | Triazine (3) | None | Perylene black (25) |
| Comparative Example 5 | Solution A | F-2 (55) | - | Melamine (15) | Triazine (3) | None | None |

### [Test of pattern formation by photolithographic method]

The resist compositions of Example 1 to Example 5 and Comparative Example 1 to Comparative Example 5, produced as described above, were each subjected to a test of pattern formation by a photolithographic method. The test of pattern formation was performed by the following two processes, in consideration of components of such each resist composition.
· Process A: application → pre-baking → exposure → development
· Process B: application → pre-baking → exposure → PEB -> development

A glass slide substrate was used as the substrate. In the application step, such each resist composition was dropped on the center of the glass slide substrate installed in a spin coater, and each uniform coating film was formed by rotation at 1000 rpm for 10 seconds. The glass slide substrate coated was pre-baked in a hot plate at 120°C for one minute and thus dried, and each resist film was thus obtained. The film thickness of such each resist film was measured with a stylus film thickness meter, and was 10 µm in each case.

In the exposure step, exposure on the substrate was made with an exposure mask having a Cr pattern being interposed. A light source was a near-infrared lamp unit (UF-120 from UniqueFire) provided with a LED chip (wavelength of emission: any of 850 nm or 940 nm). The lamp unit can approximately radiate parallel light by setting of a focus point at a long distance with a lens. In only Comparative Example 5, exposure was made with ultraviolet rays by use of a mask aligner (mixed wavelengths of g-, h-, and i-rays) as a light source. The exposure time was 3 minutes. Pattern B was subjected to post-exposure treatment (PEB) after the exposure. In this heating treatment, heating was made on a direct hot plate at 130°C for one minute.

In the development step, paddle development was made with a 1.19% tetramethylammonium hydroxide solution (TMAH solution) as a developer. Thereafter, the substrate was washed with water and dried with air blowing.

A glass slide with a black pattern, obtained in the above steps, was evaluated. In the evaluation, not only whether or not a black film (pattern) was formed on the substrate was confirmed, but also a pattern edge was observed with an optical microscope and a cross section shape was observed with an electron microscope. The rate of light blocking with the black pattern formed was measured with an OD meter (manufactured by X-Rite Inc.). The results of the test of pattern formation by a photolithographic method are shown in Table 2.

**[Table 2]**

| | Lithographic process | Exposure wavelength | Results of lithography | | |
|---|---|---|---|---|---|
| | | | OD value | Pattern edge | Cross section |
| Example 1 | A | 850 nm | 5.3 | Good (sharp) | Good (rectangle) |
| Example 2 | A | 850 nm | 5.3 | Good (sharp) | Good (rectangle) |
| Example 3 | A | 940 nm | 5.1 | Good (sharp) | Good (rectangle) |
| Example 4 | B | 850 nm | 4.8 | Good (sharp) | Good (rectangle) |
| Example 5 | B | 850 nm | 5.0 | Good (sharp) | Good (rectangle) |
| Comparative Example 1 | A | 850 nm | Image flowed | | |
| Comparative Example 2 | A | 850 nm | Image flowed | | |
| Comparative Example 3 | A | 850 nm | Image once observed, but finally flowed | | |
| Comparative Example 4 | B | 850 nm | Image flowed | | |
| Comparative Example 5 | B | Aligner | Almost transparent | Good (sharp) | Good (rectangle) |

A portion in which light was blocked with the exposure mask was completely dissolved out in the development step over 15 seconds and only a desired black pattern remained, with respect to each of the black resist compositions (negative) of Example 1 to Example 4. A portion in which light was blocked with the exposure mask remained in the development step, and an exposed portion was completely dissolved out over 15 seconds and a desired black pattern was obtained, with respect to the black resist composition (positive) of Example 5. It was confirmed by observation of the black pattern with an optical microscope that a pattern edge was very sharp and excellent in edge roughness. It was also found by the observation results of a cross section of the pattern with an electron microscope that the pattern had a rectangle very excellent in verticality. It was also confirmed from the measurement results of the rate of light blocking that the black pattern with each of the black resist compositions of Example 1 to Example 5 had an OD value of 4.8 to 5.3 and a good light-blocking effect. It was deemed from the foregoing that the black resist composition of each Example enabled a black pattern having good thickness and shape to be formed by a photolithographic method with near-infrared light. It was here also confirmed that good results were obtained by application of suitable black pigment and sensitizing dye even with respect to the three-component chemically amplified negative resist and the positive resist with de-protection reaction as in Examples 4 and 5.

On the other hand, all the resist films each were dissolved and flowed off in development, with respect to the black resist compositions of Comparative Example 1 and Comparative Example 2. It was deemed that no photoreaction due to near-infrared light occurred and no polymerization was made. It was deemed that the reason was because no sensitizing dye was included with respect to Comparative Example 1 and 9-phenylacridine, while commonly used as a photosensitizer, also generated no photoreaction due to near-infrared light with respect to Comparative Example 2.

In Comparative Example 3, the same pattern as the mask pattern was observed for a moment in development, but the resist film was immediately fully dissolved and flowed off. It was deemed that the reason was because, although reaction due to near-infrared light slightly occurred on a surface layer, carbon black absorbed and blocked near-infrared light and thus no light reached a lower portion and no sufficient polymerization was made.

In Comparative Example 4, the black film was fully dissolved and flowed off in development. The reason was because the black resist composition of Comparative Example 4, which included a suitable black pigment, included no photosensitizing dye added, and no photoreaction due to near-infrared light occurred.

In Comparative Example 5, the resist composition (solution A) included no black pigment. If the resist film was exposed to ultraviolet rays, a pattern edge was sharp and a cross section also had verticality. However, no black pigment was included and thus the OD value was equal to or less than the lower limit of the measurement limit and only an almost transparent film was obtained.

### INDUSTRIAL APPLICABILITY

According to the above-mentioned black resist composition of the present invention and the photolithographic method with near-infrared light, by use of the black resist composition, a suitable black pattern can be formed which not only is excellent in light-blocking effect, but also has a cross section rectangle having no edge roughness. The present invention is suitable for production of not only a black matrix of a color flat panel such as a liquid crystal television or a smartphone screen, but also a black pattern serving as a grid-like partition of a display device as a combination of a micro LED and a quantum dot, recently being developed.

## Claims

1. A black resist composition comprising the following component (A) to component (D) as essential components:
Component (A): a near-infrared-permeable black pigment;
Component (B): a sensitizing dye having absorption in a near-infrared region;
Component (C): a radical polymerization initiator or acid generator; and
Component (D): a binder resin.

2. The black resist composition according to claim 1, wherein the black pigment as the component (A) is a pigment allowing for permeation of 50% or more of near-infrared light at a wavelength of 700 nm or more and 1000 nm or less.

3. The black resist composition according to claim 1 or claim 2, wherein the black pigment as the component (A) is at least any of a lactam-based pigment, a perylene-based pigment, and an azomethine-based pigment.

4. The black resist composition according to any one of claim 1 to claim 3, wherein the sensitizing dye as the component (B) is a dye having absorption of near-infrared light at a wavelength of 700 nm or more and 1000 nm or less.

5. The black resist composition according to any one of claim 1 to claim 4, wherein the sensitizing dye as the component (B) is at least any of a cyanine dye, a squarylium dye, and a phthalocyanine dye.

6. The black resist composition according to any one of claim 1 to claim 5, wherein the radical polymerization initiator or acid generator as the component (C) is capable of generating radical or acid by near-infrared irradiation in the presence of the sensitizing dye as the component (B).

7. The black resist composition according to any one of claim 1 to claim 6, wherein the radical polymerization initiator or acid generator as the component (C) is an iodonium salt, a triazine compound, or a boron ion complex.

8. The black resist composition according to any one of claim 1 to claim 7, wherein the black resist composition is a negative photoresist comprising an alkali-soluble resin as the binder resin as the component (D) and further comprising any of a radical polymerizable monomer or a crosslinking agent as the component (E).

9. The black resist composition according to any one of claim 1 to claim 7, wherein the black resist composition is a positive photoresist comprising an alkali-soluble resin protected with an acid-degradable group, as the binder resin as the component (D).

10. A method for forming a black pattern by a photolithographic method comprising forming a resist film by application of a resist composition to a substrate and drying of the resultant, exposing the resist film, and developing the exposed resist film, wherein the forming method comprises
applying the black resist composition defined in any one of claim 1 to claim 9 as the resist composition, and
exposing the resist film to near-infrared light at a wavelength of 700 nm or more and 1000 nm or less in the exposure.

11. A black pattern produced by the method defined in claim 10.
